(19) Europäisches Patentamt
European Patent Office
Office européen des brevets

(11) **EP 3 009 211 B1**

(12) **EUROPÄISCHE PATENTSCHRIFT**

(45) Veröffentlichungstag und Bekanntmachung des Hinweises auf die Patenterteilung:
**14.06.2017 Patentblatt 2017/24**

(21) Anmeldenummer: **15183796.0**

(22) Anmeldetag: **04.09.2015**

(51) Int Cl.:
*B22F 1/00* (2006.01)     *B22F 1/02* (2006.01)
*B22F 7/08* (2006.01)     *B23K 35/34* (2006.01)
*B23K 35/36* (2006.01)     *B23K 35/365* (2006.01)
*B23K 35/02* (2006.01)     *H01L 23/00* (2006.01)
*B22F 7/06* (2006.01)

(54) **METALLPASTE UND DEREN VERWENDUNG ZUM VERBINDEN VON BAUELEMENTEN**

METAL PASTE AND ITS USE FOR JOINING COMPONENTS

PATE METALLIQUE ET SON UTILISATION POUR RELIER DES ELEMENTS DE CONSTRUCTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**20.04.2016 Patentblatt 2016/16**

(73) Patentinhaber: **Heraeus Deutschland GmbH & Co. KG**
**63450 Hanau (DE)**

(72) Erfinder:
• **KREBS, Thomas**
  **63776 Mömbris (DE)**
• **SCHÄFER, Michael**
  **36093 Künzell (DE)**
• **SCHMITT, Wolfgang**
  **63110 Rodgau (DE)**
• **DUCH, Susanne Klaudia**
  **63486 Bruchköbel (DE)**
• **NACHREINER, Jens**
  **36381 Schlüchtern (DE)**

(56) Entgegenhaltungen:
**WO-A1-2011/026623     US-A1- 2011 290 863**
**US-A1- 2014 026 953**

**Beschreibung**

Die vorliegende Erfindung betrifft eine Metallpaste und ein Verfahren zum Verbinden von Bauelementen, bei dem diese Metallpaste eingesetzt wird.

Im Bereich der Leistungs- und Konsumerelektronik stellt das Verbinden von Bauelementen, wie LEDs oder sehr dünnen Siliziumchips, die eine hohe Druck- und Temperaturempfindlichkeit aufweisen, eine besondere Herausforderung dar.

Aus diesem Grund werden solche druck- und temperaturempfindlichen Bauelemente häufig durch Kleben miteinander verbunden. Die Klebetechnik besitzt jedoch den Nachteil, dass damit Kontaktstellen zwischen den Bauelementen geschaffen werden, die eine nur unzureichende Wärmeleitfähigkeit bzw. elektrische Leitfähigkeit aufweisen.

Um dieses Problem zu lösen, werden die zu verbindenden Bauelemente häufig gesintert. Die Sintertechnik stellt ein sehr einfaches Verfahren zum stabilen Verbinden von Bauelementen dar.

Der Einsatz von Metallpasten in einem Sinterprozess zum Verbinden von Bauelementen im Bereich der Leistungselektronik ist bekannt. Beispielsweise offenbart WO2011/026623 A1 eine Metallpaste enthaltend 75 bis 90 Gew.-% (Gewichtsprozent) wenigstens eines Metalls, das in Form von Partikeln vorliegt, die ein Coating aufweisen, das wenigstens eine organische Verbindung enthält, 0 bis 12 Gew.-% wenigstens eines Metallprecursors, 6 bis 20 Gew.-% wenigstens eines Lösemittels und 0,1 bis 15 Gew.-% wenigstens eines Sinterhilfsmittels, sowie die Verwendung der Metallpaste zur Verbindung von Bauelementen mittels eines Sinterverfahrens.

DE 10 2009 000 192 A1 offenbart in einem Sinterverfahren zur Verbindung von Bauelementen verwendbare Sinterwerkstoffe, die organisch beschichtete Kupfer-, Silber- und/oder Goldpartikel als Strukturpartikel und nicht organisch beschichtete (unbeschichtete) metallische und/oder keramische Hilfspartikel enthält. Im Falle metallischer Hilfspartikel wird auf die Möglichkeit hingewiesen, dass diese aus demselben Material ausgebildet sein können wie die Strukturpartikel (jedoch ohne organische Beschichtung).

Aufgabe der Erfindung ist die Bereitstellung eines Sinterverfahrens zur stabilen Verbindung von Bauelementen. Mit dem Verfahren sollen Kontaktstellen zwischen den zu verbindenden Bauelementen gebildet werden, die eine niedrige Porosität und eine hohe elektrische und thermische Leitfähigkeit aufweisen. Das Sinterverfahren soll zur stabilen Verbindung von Bauelementen sowohl unter Drucksinterbe-dingungen als auch für ein druckloses Sintern geeignet sein. Die mit dem Verfahren geschaffenen Sinterverbindungen in Form von zwischen den verbundenen Bauelementen ausgebildeten Sinterschichten (gesinterte Schichten) sollen auch nach dauerhafter Temperaturbelastung, wie sie unter Gebrauchsbedingungen auftreten kann, möglichst wenig verspröden und möglichst keine oder nur geringe innere mechanische Spannungen ausbilden. Versprödung und mechanische Spannungen innerhalb einer Bauelemente verbindenden Sinterschicht schwächen die Festigkeit einer solchen Verbindung oder zerstören letztere sogar, ein Problem, dem besondere Bedeutung bei der Verbindung großflächiger Bauelemente, beispielsweise großflächige Kühlkörper oder großflächige Chips, zukommt. Beispiele für großflächige Bauelemente sind solche mit einer Kontaktfläche von > 16 mm$^2$, beispielsweise im Bereich von > 16 bis 12000 mm$^2$. Beispiele sind rechteckige Bauelemente mit einer Kantenlänge ihrer rechteckigen Kontaktfläche von jeweils > 4 mm, wobei die längere Kante beispielsweise bis zu 150 mm lang sein kann. Eine weitere Aufgabe der vorliegenden Erfindung besteht darin, eine zur Durchführung eines derartigen Sinterverfahrens geeignete Metallpaste bereitzustellen.

Die Erfindung betrifft ein Verfahren zum Verbinden von Bauelementen, bei dem man (a) eine Sandwichanordnung bereitstellt, die wenigstens (a1) ein Bauelement 1, (a2) ein Bauelement 2 und (a3) eine Metallpaste aufweist, die sich zwischen Bauelement 1 und Bauelement 2 befindet, und (b) die Sandwichanordnung sintert, wobei die Metallpaste (A) 75 bis 90 Gew.-% Kupfer- und/oder Silberpartikel, die ein Coating aufweisen, das wenigstens eine organische Verbindung enthält, (B) 5 bis 20 Gew.-% organisches Lösemittel und (C) 2 bis 20 Gew.-% mindestens einer Art von von Partikeln (A) verschiedenen Metallpartikeln mit einer mittleren Teilchengröße (d50) im Bereich von 0,2 bis 10 μm enthält, wobei die Metallpartikel der Komponente (C) ausgewählt sind aus der aus Molybdänpartikeln und Nickelkern-Silbermantel-Partikeln mit einem Silbergehalt von 10 bis 90 Gew.-% bestehenden Gruppe.

Die Erfindung betrifft ferner eine Metallpaste, die (A) 75 bis 90 Gew.-% Kupfer- und/oder Silberpartikel, die ein Coating aufweisen, das wenigstens eine organische Verbindung enthält, (B) 5 bis 20 Gew.-% organisches Lösemittel und (C) 2 bis 20 Gew.-% mindestens einer Art von von Partikeln (A) verschiedenen Metallpartikeln mit einer mittleren Teilchengröße (d50) im Bereich von 0,2 bis 10 μm enthält, wobei die Metallpartikel der Komponente (C) ausgewählt sind aus der aus Molybdänpartikeln und Nickelkern-Silbermantel-Partikeln mit einem Silbergehalt von 10 bis 90 Gew.-% bestehenden Gruppe.

Der in der Beschreibung und den Ansprüchen verwendete Begriff "mittlere Teilchengröße" bedeutet den mittels Laserbeugung bestimmbaren mittleren Primärteilchendurchmesser ($d_{50}$). Laserbeugungsmessungen können mit einem entsprechenden Teilchengrößenmessgerät, beispielsweise einem Mastersizer 3000 von Malvern Instruments durchgeführt werden.

Die erfindungsgemäße Metallpaste enthält als Komponente (A) 75 bis 90 Gew.-%, vorzugsweise 77 bis 89 Gew.-%, mehr bevorzugt 78 bis 87 Gew.-% und noch mehr bevorzugt 78 bis 86 Gew.-% Kupfer- und/oder Silberpartikel, die ein Coating aufweisen, das wenigstens eine organische Verbindung enthält. Die hier gemachten Gewichtsangaben schließen das Gewicht der Coatingverbindungen auf den Partikeln mit ein.

Unter den Begriff Kupfer- und/oder Silberpartikel (A) fallen sowohl Partikel der reinen Metalle (Reinheit von wenigstens 99,9 Gew.-%) als auch Legierungen mit bis zu 10 Gew.-% wenigstens eines anderen Legierungsmetalls. Beispiele für geeignete Legierungsmetalle sind Kupfer, Silber, Gold, Nickel, Palladium, Platin und Aluminium.

Bevorzugt als Komponente (A) sind Silberpartikel, insbesondere solche aus reinem Silber.

Die Kupfer- und/oder Silberpartikel (A) können von unterschiedlicher Gestalt sein. Beispielsweise können sie in der Form von Flakes oder einer sphärischen (kugeligen) Form vorliegen. Gemäß einer besonders bevorzugten Ausführungsform weisen sie die Form von Flakes auf. Dies schließt jedoch nicht aus, dass von den eingesetzten Kupfer- und/oder Silberpartikeln auch ein untergeordneter Anteil eine andere Form aufweisen kann. Es ist jedoch bevorzugt, dass wenigstens 70 Gew.-%, mehr bevorzugt wenigstens 80 Gew.-%, noch mehr bevorzugt wenigstens 90 Gew.-% oder 100 Gew.-% der Kupfer- und/oder Silberpartikel in der Form von Flakes vorliegen.

Die Kupfer- und/oder Silberpartikel sind gecoatet.

Unter einem Coating von Partikeln wird eine festhaftende Schicht auf der Oberfläche von Partikeln verstanden.

Das Coating der Kupfer- und/oder Silberpartikel enthält wenigstens eine Art von Coatingverbindungen.

Bei diesen Coatingverbindungen handelt es sich um organische Verbindungen.

Bei den organischen Verbindungen, die als Coatingverbindungen dienen, handelt es sich um kohlenstoffhaltige Verbindungen, die eine Agglomeration der Kupfer- und/oder Silberpartikel verhindern.

Gemäß einer bevorzugten Ausführungsform tragen die Coatingverbindungen wenigstens eine funktionelle Gruppe. Als funktionelle Gruppen kommen insbesondere Carbonsäuregruppen, Carboxylatgruppen, Estergruppen, Ketogruppen, Aldehydgruppen, Aminogruppen, Amidgruppen, Azogruppen, Imidgruppen oder Nitrilgruppen in Betracht. Bevorzugte funktionelle Gruppen sind Carbonsäuregruppen und Carbonsäureestergruppen. Die Carbonsäuregruppe kann deprotoniert sein.

Bei den Coatingverbindungen mit wenigstens einer funktionellen Gruppe handelt es sich vorzugsweise um gesättigte, einfach ungesättigte oder mehrfach ungesättigte organische Verbindungen.

Diese Coatingverbindungen mit wenigstens einer funktionellen Gruppe können ferner verzweigt oder unverzweigt sein.

Die Coatingverbindungen mit wenigstens einer funktionellen Gruppe weisen vorzugsweise 1 bis 50, mehr bevorzugt 2 bis 24, noch mehr bevorzugt 6 bis 24 und noch mehr bevorzugt 8 bis 20 Kohlenstoffatome auf.

Die Coatingverbindungen können ionisch oder nichtionisch sein.

Vorzugsweise kommen als Coatingverbindungen freie Fettsäuren, Fettsäuresalze oder Fettsäureester zum Einsatz.

Die freien Fettsäuren, Fettsäuresalze und Fettsäureester sind vorzugsweise unverzweigt.

Ferner sind die freien Fettsäuren, Fettsäuresalze oder Fettsäureester vorzugsweise gesättigt.

Bevorzugte Fettsäuresalze sind die Salze von Ammonium, Monoalkylammonium, Dialkylammonium, Trialkylammonium, Aluminium, Kupfer, Lithium, Natrium und Kalium. Bevorzugte Ester sind Alkylester, insbesondere Methylester, Ethylester, Propylester und Butylester.

Gemäß einer bevorzugten Ausführungsform handelt es sich bei den freien Fettsäuren, Fettsäuresalzen oder Fettsäureestern um Verbindungen mit 8 bis 24, mehr bevorzugt 8 bis 18 Kohlenstoffatomen.

Bevorzugte Coatingverbindungen sind Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure), Lignocerinsäure (Tetracosansäure) sowie die entsprechenden Ester und Salze.

Besonders bevorzugte Coatingverbindungen sind Dodecansäure, Octadecansäure, Aluminiumstearat, Kupferstearat, Natriumstearat, Kaliumstearat, Natriumpalmitat und Kaliumpalmitat.

Die Coatingverbindungen können mittels herkömmlicher und aus dem Stand der Technik bekannter Verfahren auf die Oberfläche der Kupfer- und/oder Silberpartikel (A) aufgetragen werden.

Beispielsweise ist es möglich, die Coatingverbindungen, insbesondere die vorstehend erwähnten Stearate oder Palmitate, in Lösemitteln aufzuschlämmen und die aufgeschlämmten Coatingverbindungen in Kugelmühlen mit den Kupfer- und/oder Silberpartikeln zu vermahlen. Nach dem Mahlen werden die mit den Coatingverbindungen beschichteten Kupfer- und/oder Silberpartikel getrocknet und anschließend entstaubt.

Vorzugsweise beträgt der Anteil an organischen Verbindungen, insbesondere der Anteil an Verbindungen, die aus der Gruppe ausgewählt sind, die aus freien Fettsäuren, Fettsäuresalzen und Fettsäureestern besteht, an dem gesamten Coating wenigstens 60 Gew.-%, mehr bevorzugt wenigstens 70 Gew.-%, noch mehr bevorzugt wenigstens 80 Gew.-%, noch mehr bevorzugt wenigstens 90 Gew.-%, insbesondere wenigstens 95 Gew.-%, wenigstens 99 Gew.-% oder 100 Gew.-%.

Der Anteil der Coatingverbindungen, vorzugsweise der Coatingverbindungen, die aus der Gruppe ausgewählt sind, die aus freien Fettsäuren, Fettsäuresalzen und Fettsäureestern besteht, beträgt < 5 Gew.-%, beispielsweise 0,01 bis 2 Gew.-%, vorzugsweise 0,3 bis 1,5 Gew.-%, bezogen auf das Gewicht der gecoateten Kupfer- und/oder Silberpartikel.

Der Coatinggrad, der als Verhältnis der Masse an Coatingverbindungen zur Oberfläche der Kupfer- und/oder Silberpartikel definiert ist, beträgt vorzugsweise 0,00005 bis 0,03 g, mehr bevorzugt 0,0001 bis 0,02 g an Coatingverbindungen pro Quadratmeter ($m^2$) Oberfläche der Kupfer- und/oder Silberpartikel.

Die erfindungsgemäße Metallpaste enthält als Bestandteil (B) 6 bis 20 Gew.-%, vorzugsweise 7 bis 18 Gew.-%, mehr bevorzugt 8 bis 17 Gew.-% und noch mehr bevorzugt 10 bis 15 Gew.-% organisches Lösemittel, d.h. ein organisches Lösemittel oder ein Gemisch mindestens zweier organischer Lösemittel.

Bei dem oder den organischen Lösemitteln (B) handelt es sich um für Metallpasten üblicherweise verwendete organische Lösemittel. Beispiele sind Terpineole, N-Methyl-2-pyrrolidon, Ethylenglykol, Dimethylacetamid, 1-Tridecanol, 2-Tridecanol, 3-Tridecanol, 4-Tridecanol, 5-Tridecanol, 6-Tridecanol, Isotridecanol, mit Ausnahme einer Methylsubsitution am vorletzten C-Atom unsubstituierte 1-Hydroxy-C16-C20-alkane wie 16-Methylheptadecan-1-ol, dibasische Ester (vorzugsweise Dimethylester der Glutar-, Adipin- oder Bernsteinsäure oder Mischungen davon), Glycerin, Diethylenglykol, Triethylenglykol und aliphatische, insbesondere gesättigte aliphatische Kohlenwasserstoffe mit 5 bis 32 C-Atomen, mehr bevorzugt 10 bis 25 C-Atomen und noch mehr bevorzugt 16 bis 20 C-Atomen. Solche aliphatischen Kohlenwasserstoffe werden beispielsweise von Exxon Mobil unter der Marke Exxsol™ D140 oder unter der Marke Isopar M™ vertrieben.

Es ist erfindungswesentlich, dass die Metallpaste als Bestandteil (C) 2 bis 20 Gew.-% mindestens einer Art von von Partikeln (A) verschiedenen Metallpartikeln mit einer mittleren Teilchengröße (d50) im Bereich von 0,2 bis 10 μm enthält, wobei die Metallpartikel der Komponente (C) ausgewählt sind aus der aus Molybdänpartikeln und Nickelkern-Silbermantel-Partikeln mit einem Silbergehalt von 10 bis 90 Gew.-%, bevorzugt 15 bis 30 Gew.-%, insbesondere 25 Gew.-% bestehenden Gruppe.

Die den Bestandteil (C) bildenden Partikel unterscheiden sich von den Kupfer- und/oder Silberpartikeln (A). Es handelt sich entweder um Molybdänpartikel oder um Nickelkern-Silbermantel-Partikel [mit Silber beschichtete (ummantelte) Nickelpartikel] mit einem Silbergehalt von 10 bis 90 Gew.-%, bevorzugt 15 bis 30 Gew.-%, insbesondere 25 Gew.-% oder um Kombinationen von Molybdänpartikeln und Nickelkern-Silbermantel-Partikeln mit einem Silbergehalt von 10 bis 90 Gew.-%, bevorzugt 15 bis 30 Gew.-%, insbesondere 25 Gew.-%. Mit anderen Worten, die Silbermäntel der Nickelkern-Silbermantel-Partikel machen 10 bis 90 Gew.-%, bevorzugt 15 bis 30 Gew.-%, insbesondere 25 Gew.-% des Gesamtgewichts der Nickelkern-Silbermantel-Partikel aus.

Die Partikel (C) umfassen insbesondere weder Flakes noch Nadeln, speziell weisen sie einen Formfaktor im Bereich von beispielsweise 1 bis 3, bevorzugt 1 bis 2 auf.

Der hierin verwendete Begriff "Formfaktor" bezieht sich auf die Form von Partikeln und bedeutet den Quotienten aus der größten und der kleinsten Längenausdehnung eines Teilchens. Er kann bestimmt werden durch Auswertung mikroskopischer Bilder im Sinne einer Vermessung der Dimensionen einer statistisch sinnvollen Anzahl beispielsweise 2500 bis 3000 individueller Teilchen. Beispielsweise kann dazu ein optisches Mikroskop bei 5000-facher Vergrößerung gekoppelt mit einem automatischen Bildanalyse-System verwendet werden.

Partikel mit einem Formfaktor im genannten Bereich von 1 bis 3 oder 1 bis 2 zeichnen sich aus beispielsweise durch eine Kugelgestalt (Formfaktor 1), eine im wesentlichen kugelige Gestalt, eine elliptische oder eiförmige Gestalt, eine irreguläre aber kompakte Gestalt, die Gestalt einer sogenannten coin, etc., in jedem Falle jedoch durch eine Gestalt, die abweicht von der von Plättchen (Flakes) oder Nadeln. Die Oberfläche der Partikel (C) kann glatt oder unregelmäßig, beispielsweise rau oder gratig sein.

In einer Ausführungsform haben die den Bestandteil (C) bildenden Nickelkern-Silbermantel-Partikel kein Coating.

Die erfindungsgemäße Metallpaste kann 0 bis 12 Gew.-%, vorzugsweise 0,1 bis 12 Gew.-%, mehr bevorzugt 1 bis 10 Gew.-% und noch mehr bevorzugt 2 bis 8 Gew.-% wenigstens eines Metallprecursors (D) enthalten.

Unter Metallprecursor wird im Rahmen der Erfindung eine Verbindung verstanden, die wenigstens ein Metall enthält. Vorzugsweise handelt es sich dabei um eine Verbindung, die sich bei Temperaturen von unter 200°C unter Freisetzung eines Metalls zersetzt. Vorzugsweise wird demnach bei Verwendung eines Metallprecursors beim Sinterprozess in situ ein Metall gebildet. Es kann auf einfache Weise ermittelt werden, ob es sich bei einer Verbindung um einen Metallprecursor handelt. So kann beispielsweise eine Paste, die eine zu testende Verbindung enthält, auf ein Substrat mit einer Silberoberfläche abgeschieden, auf 200°C erhitzt und bei dieser Temperatur für 20 Minuten belassen werden. Danach wird überprüft, ob sich die zu testende Verbindung unter diesen Bedingungen zu einem Metall zersetzt hat. Hierzu kann beispielsweise vor dem Test der Gehalt der metallhaltigen Pastenbestandteile ausgewogen und daraus die theoretische Masse des Metalls berechnet werden. Nach dem Test wird die Masse des auf dem Substrat abgeschiedenen Materials gravimetrisch bestimmt. Entspricht die Masse des auf dem Substrat abgeschiedenen Materials der theoretischen Masse des Metalls, wobei die üblichen Messabweichungen zu berücksichtigen sind, handelt es sich bei der getesteten Verbindung um einen Metallprecursor.

Gemäß einer bevorzugten Ausführungsform handelt es sich bei dem Metallprecursor um einen endotherm zersetzbaren Metallprecursor. Unter endotherm zersetzbarem Metallprecursor soll ein Metallprecursor verstanden werden, dessen thermische Zersetzung, vorzugsweise unter Schutzgasatmosphäre, einen endothermen Vorgang darstellt. Bei dieser thermischen Zersetzung soll es zur Freisetzung von Metall aus dem Metallprecursor kommen.

Vorzugsweise umfasst der Metallprecursor als Metall wenigstens ein Element, das aus der Gruppe ausgewählt ist, die aus Kupfer, Silber, Gold, Nickel, Palladium und Platin, insbesondere aus Kupfer und Silber, besteht.

Es kann bevorzugt sein, als Metallprecursor endotherm zersetzbare Carbonate, Lactate, Formiate, Citrate, Oxide oder Fettsäuresalze, vorzugsweise Fettsäuresalze mit 6 bis 24 Kohlenstoffatomen, der genannten Metalle zu verwenden.

In besonderen Ausführungsformen werden als Metallprecursor Silbercarbonat, Silberlactat, Silberformiat, Silbercitrat, Silberoxid (zum Beispiel AgO oder $Ag_2O$), Kupferlactat, Kupferstearat, Kupferoxide (zum Beispiel $Cu_2O$ oder CuO) eingesetzt.

Gemäß einer besonders bevorzugten Ausführungsform wird als Metallprecursor Silbercarbonat und/oder Silberoxid verwendet.

Falls vorhanden, liegt der Metallprecursor in der Metallpaste vorzugsweise in der Form von Partikeln vor.

Die Metallprecursor-Partikel können die Form von Flakes oder eine sphärische (kugelige) Form aufweisen. Vorzugsweise liegen die Partikel des Metallprecursors als Flakes vor.

Die erfindungsgemäße Metallpaste kann ferner 0 bis 10 Gew.-%, vorzugsweise 0 bis 8 Gew.-% wenigstens eines Sinterhilfsmittels (E) enthalten. Beispiele für Sinterhilfsmittel sind organische Peroxide, anorganische Peroxide und anorganische Säuren, wie beispielsweise in WO2011/026623 A1 beschrieben.

Die erfindungsgemäße Metallpaste kann neben den vorstehend erläuterten Bestandteilen (A) bis (E) 0 bis 15 Gew.-%, vorzugsweise 0 bis 12 Gew.-%, mehr bevorzugt 0,1 bis 10 Gew.-% eines oder mehrerer weiterer Inhaltsstoffe (F) enthalten. Bei diesen weiteren Inhaltsstoffen kann es sich vorzugsweise um üblicherweise in Metallpasten eingesetzte Inhaltsstoffe handeln. Beispielsweise können in der Metallpaste als weitere Inhaltsstoffe Dispersionsmittel, Tenside, Entschäumer, Bindemittel, Polymere wie Cellulosederivate, beispielsweise Methylcellulose, Ethylcellulose, Ethylmethylcellulose, Carboxycellulose, Hydroxypropylcellulose, Hydroxyethylcellulose, Hydroxymethylcellulose, und/oder viskositätssteuernde Mittel enthalten sein.

Die Summe der Gew.-% der Bestandteile (A) bis (F) beträgt beispielsweise 100 Gew.-%, bezogen auf die erfindungsgemäße Metallpaste, d.h. vor ihrer Applikation. Dementsprechend kann die Herstellung der erfindungsgemäßen Metallpaste durch Vermischen der Bestandteile (A) bis (F) erfolgen. Dabei können übliche dem Fachmann bekannte Vorrichtungen verwendet werden, beispielsweise Rührwerke und Dreiwalzwerke.

Die erfindungsgemäße Metallpaste kann insbesondere als Sinterpaste, d.h. in einem Sinterverfahren eingesetzt werden. Unter Sintern wird das Verbinden von zwei oder mehr Bauelementen durch Erhitzen unter Vermeidung dessen, dass die Kupfer- und/oder Silberpartikel (A) die flüssige Phase erreichen, verstanden.

Das unter Verwendung der erfindungsgemäßen Metallpaste durchgeführte Sinterverfahren kann unter Druckanwendung oder drucklos durchgeführt werden. Drucklose Durchführbarkeit des Sinterverfahrens bedeutet, dass trotz Verzichts auf die Anwendung von Druck eine hinreichend feste Verbindung zwischen Bauelementen erzielt wird. Die Möglichkeit, den Sinterprozess drucklos durchzuführen, erlaubt es, druckempfindliche, beispielsweise zerbrechliche oder in ihrem Gefüge mechanisch empfindliche Bauelemente im Sinterverfahren einzusetzen. In ihrem Gefüge mechanisch empfindliche Elektronikbauelemente erleiden bei unzulässiger Druckbelastung elektrische Fehlfunktionen.

Unter dem Verbinden von wenigstens zwei Bauelementen wird das Befestigen von einem ersten Bauelement auf einem zweiten Bauelement verstanden. In diesem Zusammenhang bedeutet "auf" lediglich, dass eine Oberfläche des ersten Bauelements mit einer Oberfläche des zweiten Bauelements verbunden wird, wobei es auf die relative Lage der beiden Bauelemente oder der Anordnung, die die wenigstens zwei Bauelemente enthält, nicht ankommt.

Im Rahmen der Erfindung soll der Begriff Bauelement vorzugsweise Einzelteile umfassen. Diese Einzelteile sind vorzugsweise nicht weiter zerlegbar.

Gemäß besonderen Ausführungsformen werden als Bauelemente Teile bezeichnet, die in der Elektronik verwendet werden.

Demgemäß kann es sich bei den Bauelementen beispielsweise um Dioden, LEDs (light emitting diodes, lichtemittierende Dioden), DCB (direct copper bonded)-Substrate, Leadframes, Dies, IGBTs (insulated-gate bipolar transistors, Bipolartransistoren mit isolierter Gate-Elektrode), ICs (integrated circuits, integrierte Schaltungen), Sensoren, Kühlkörper (vorzugsweise Aluminium-Kühlkörper oder Kupfer-Kühlkörper) oder andere passive Bauelemente (zum Beispiel Widerstände, Kondensatoren oder Spulen) handeln. Wie in der Aufgabenstellung schon angedeutet, können die Bauelemente insbesondere auch großflächige Bauelemente, wie weiter vorne beschrieben, umfassen.

Die zu verbindenden Bauelemente können gleichartige oder verschiedenartige Bauelemente sein.

Ausführungsformen der Erfindung betreffen die Verbindung von LED mit Leadframe, von LED mit keramischem Substrat, von Dies, Dioden, IGBTs oder ICs mit Leadframes, keramischen Substraten oder DCB-Substraten, von Sensor mit Leadframe oder keramischem Substrat.

Die Bauelemente, beispielsweise wenigstens eines der Bauelemente 1 und 2, können - soweit sie nicht ohnehin aus Metall bestehen - wenigstens eine Metallkontaktfläche beispielsweise in Form einer Metallisierungsschicht, umfassen, worüber die schon erwähnte Sandwichanordnung im Rahmen des erfindungsgemäßen Verfahrens erfolgt. Diese Metallisierungsschicht ist vorzugsweise Teil des Bauelements. Die Metallisierungsschicht befindet sich vorzugsweise an wenigstens einer Oberfläche des Bauelements.

Bevorzugt wird die Verbindung der Bauelemente mittels der erfindungsgemäßen Metallpaste über besagte Metallisierungsschicht bzw. -schichten vorgenommen.

Die Metallisierungsschicht kann reines Metall aufweisen. So kann es bevorzugt sein, wenn die Metallisierungsschicht wenigstens 50 Gew.-%, mehr bevorzugt wenigstens 70 Gew.-%, noch mehr bevorzugt wenigstens 90 Gew.-% oder aber 100 Gew.-% an reinem Metall aufweist. Das reine Metall ist beispielsweise aus der Gruppe ausgewählt, die aus Aluminium, Kupfer, Silber, Gold, Palladium und Platin besteht.

Andererseits kann die Metallisierungsschicht auch eine Legierung aufweisen. Die Legierung der Metallisierungsschicht enthält vorzugsweise wenigstens ein Metall, das aus der Gruppe ausgewählt ist, die aus Aluminium, Silber, Kupfer, Gold, Nickel, Palladium und Platin besteht.

Die Metallisierungsschicht kann auch einen mehrlagigen Aufbau aufweisen. So kann es beispielsweise bevorzugt sein, wenn wenigstens eine Oberfläche der zu verbindenden Bauelemente eine Metallisierungsschicht aus mehreren Lagen umfasst, die die vorstehend genannten reinen Metalle und/oder Legierungen aufweisen.

Im erfindungsgemäßen Verfahren werden wenigstens zwei Bauelemente durch Sintern miteinander verbunden.

Dazu werden zunächst die zwei oder mehr Bauelemente miteinander in Kontakt gebracht. Das Kontaktieren erfolgt dabei über die erfindungsgemäße Metallpaste. Zu diesem Zweck wird eine Anordnung bereitgestellt, bei der sich zwischen jeweils zwei der wenigstens zwei Bauelemente erfindungsgemäße Metallpaste befindet.

Sollen daher zwei Bauelemente, Bauelement 1 und Bauelement 2, miteinander verbunden werden, so befindet sich die erfindungsgemäße Metallpaste vor dem Sintern zwischen Bauelement 1 und Bauelement 2. Andererseits ist es denkbar, dass mehr als zwei Bauelemente miteinander verbunden werden. Beispielsweise können drei Bauelemente, Bauelement 1, Bauelement 2 und Bauelement 3, auf eine Weise miteinander verbunden werden, dass Bauelement 2 zwischen Bauelement 1 und Bauelement 3 liegt. In diesem Fall befindet sich die erfindungsgemäße Metallpaste sowohl zwischen Bauelement 1 und Bauelement 2 als auch zwischen Bauelement 2 und Bauelement 3.

Die einzelnen Bauelemente liegen in einer Sandwichanordnung vor und werden miteinander verbunden. Unter Sandwichanordnung ist eine Anordnung zu verstehen, bei der sich zwei Bauelemente übereinander befinden und die Bauelemente im Wesentlichen parallel zueinander angeordnet sind.

Die Anordnung aus wenigstens zwei Bauelementen und erfindungsgemäßer Metallpaste, wobei sich die Metallpaste zwischen zwei Bauelementen dieser Anordnung befindet, kann nach einem aus dem Stand der Technik bekannten Verfahren hergestellt werden.

Vorzugsweise wird zunächst wenigstens eine Oberfläche eines Bauelements 1 mit der erfindungsgemäßen Metallpaste versehen. Anschließend wird ein anderes Bauelement 2 mit einer seiner Oberflächen auf die Metallpaste, die auf die Oberfläche des Bauelements 1 aufgetragen worden ist, aufgesetzt.

Die Auftragung der erfindungsgemäßen Metallpaste auf die Oberfläche eines Bauelements kann mittels herkömmlicher Verfahren erfolgen, beispielsweise mittels Druckverfahren wie Siebdruck oder Schablonendruck. Andererseits kann die Auftragung der erfindungsgemäßen Metallpaste auch mittels Dispenstechnik, mittels Pintransfer oder durch Dippen erfolgen.

Im Anschluss an die Auftragung der erfindungsgemäßen Metallpaste wird vorzugsweise die mit der Metallpaste versehene Oberfläche dieses Bauelements mit einer Oberfläche des damit zu verbindenden Bauelements über die Metallpaste in Kontakt gebracht. Somit befindet sich zwischen den zu verbindenden Bauelementen eine Schicht erfindungsgemäße Metallpaste.

Die Nassschichtdicke zwischen den zu verbindenden Bauelementen liegt vorzugsweise im Bereich von 20 bis 100 $\mu$m. Unter Nassschichtdicke wird hier der Abstand zwischen den sich gegenüberliegenden Oberflächen der zu verbindenden Bauelemente vor einem gegebenenfalls stattfindenden Trocknen und vor dem Sintern verstanden. Die bevorzugte Nassschichtdicke ist abhängig vom gewählten Verfahren zum Auftragen der Metallpaste. Wird die Metallpaste beispielsweise mittels Siebdruckverfahren aufgetragen, dann kann eine Nassschichtdicke von 20 bis 50 $\mu$m bevorzugt sein. Erfolgt die Auftragung der Metallpaste mittels Schablonendruck, dann kann die bevorzugte Nassschichtdicke im Bereich von 20 bis 100 $\mu$m liegen. Bei der Dispenstechnik kann die bevorzugte Nassschichtdicke im Bereich von 20 bis 100 $\mu$m liegen.

Optional wird vor dem Sintern ein Trocknungsschritt durchgeführt, d.h. eine Entfernung von organischem Lösemittel aus der applizierten Metallpaste. Gemäß einer bevorzugten Ausführungsform liegt der Anteil an organischem Lösemittel in der Metallpaste nach der Trocknung beispielsweise bei 0 bis 5 Gew.-%, bezogen auf den ursprünglichen Anteil an organischem Lösemittel in der erfindungsgemäßen Metallpaste, d.h. applikationsbereiten Metallpaste. Mit anderen Worten, gemäß dieser bevorzugten Ausführungsform werden beispielsweise 95 bis 100 Gew.-% der ursprünglich in der erfindungsgemäßen Metallpaste enthaltenen organischen Lösemittel bei der Trocknung entfernt.

Findet ein Trocknen statt, so kann die Trocknung im Falle des drucklosen Sinterns nach der Herstellung der Anordnung, also nach der Kontaktierung der zu verbindenden Bauelemente erfolgen. Im Falle des Drucksinterns kann die Trocknung auch nach dem Auftragen der Metallpaste auf die wenigstens eine Oberfläche des Bauelements und vor der Kontaktierung mit dem zu verbindenden Bauelement erfolgen.

Die Trocknungstemperatur liegt vorzugsweise im Bereich von 100 bis 150 °C.

Es versteht sich, dass die Trocknungszeit abhängig ist von der Zusammensetzung der erfindungsgemäßen Metallpaste und der Größe der Verbindungsfläche der zu sinternden Anordnung. Übliche Trocknungszeiten liegen im Bereich von 5 bis 45 Minuten.

Die Anordnung aus den wenigstens zwei Bauelementen und zwischen den Bauelementen befindlicher Metallpaste wird schließlich einem Sinterprozess unterworfen.

Das eigentliche Sintern erfolgt bei einer Temperatur von beispielsweise 200 bis 280 °C entweder als druckloser Prozess oder als Drucksintern.

Beim Drucksintern liegt der Prozessdruck vorzugsweise unter 30 MPa und mehr bevorzugt unter 5 MPa. Beispielsweise liegt der Prozessdruck im Bereich von 1 bis 30 MPa und mehr bevorzugt im Bereich von 1 bis 5 MPa.

Die Sinterzeit liegt beispielsweise im Bereich von 2 bis 60 Minuten, beim Drucksintern beispielsweise im Bereich von 2 bis 5 Minuten, beim Drucklossintern beispielsweise im Bereich von 30 bis 60 Minuten.

Der Sinterprozess kann in einer Atmosphäre erfolgen, die keinen besonderen Beschränkungen unterliegt. So kann das Sintern einerseits in einer Atmosphäre durchgeführt werden, die Sauerstoff enthält. Andererseits ist es auch möglich, das Sintern in sauerstofffreier Atmosphäre durchzuführen. Unter sauerstofffreier Atmosphäre ist im Rahmen der Erfindung eine Atmosphäre zu verstehen, deren Sauerstoffgehalt nicht mehr als 10 ppm, vorzugsweise nicht mehr als 1 ppm und noch mehr bevorzugt nicht mehr als 0,1 ppm beträgt.

Das Sintern wird in einer herkömmlichen, zum Sintern geeigneten Vorrichtung durchgeführt, in der sich die vorstehend beschriebenen Prozessparameter einstellen lassen.

Neben der Erfüllung grundlegender Anforderungen wie Scherfestigkeit zeichnen sich die aus einer erfindungsgemäßen Metallpaste bzw. die beim erfindungsgemäßen Verfahren unter Verwendung einer erfindungsgemäße Metallpaste hergestellten Verbindungen in Form von Bauelemente verbindenden Sinterschichten aus durch ein vorteilhaftes Verhalten auch nach Temperaturdauerbelastung von beispielsweise 100 oder 200 Stunden bei 200 °C. So kommt es nur zu einer geringen Versprödung und Ausbildung nur geringer innerer Spannungen. Das Versprödungsverhalten sowie das Ausmaß der Ausbildung innerer Spannungen lässt sich im Labor an freien Sinterschichten untersuchen. Dazu können freie Sinterschichten beispielsweise von 2,5 cm Länge, 1 cm Breite und 100 $\mu$m Dicke hergestellt werden, indem man eine zu untersuchende Metallpaste auf eine oxidierte Kupferfolie mittels Schablonendruck aufbringt, danach in üblicher Weise bei erhöhter Temperatur sintert und anschließend von der oxidierten Kupferfolie ablöst. Die Oxidschicht der oxidierten Kupferfolie dient der einfachen Enthaftung beim Ablösen der Sinterschicht. Die so hergestellten freien Sinterschichten können dann vor und nach einer Temperaturdauerbelastung von beispielsweise 100 oder 200 Stunden bei 200 °C auf ihr Versprödungsverhalten durch Bestimmung des Elastizitätsmoduls und der ein Maß für die Ausbildung innerer Spannungen darstellende Wölbung (englisch: warpage oder bowing) untersucht werden. Der Elastizitätsmodul E kann aus der mittels Biegeversuch unter Verwendung einer Biegevorrichtung mit zwei Auflagerrollen und einem Biegestempel gemäß DIN EN ISO 7438:2012-03 ermittelten Biegekraft X nach folgender Formel berechnet werden:

$$E = (l^3 \cdot X) : (4D \cdot b \cdot a^3)$$

- l: Stützweite in mm
- X: Kraft in kN, gemessen bei Ende der Biegemodulermittlung (Start der Biegemodulermittlung bei 0 kN)
- D: Durchbiegung in mm
- b: Probenbreite in mm
- a: Probendicke in mm

Höhere Elastizitätsmodule stehen dabei für höhere Sprödigkeit; mit anderen Worten, je geringer der Anstieg des Elastizitätsmoduls eines Sinterschichtprobekörpers nach Temperaturdauerbelastung gegenüber dem Ausgangswert eines unbelasteten Sinterschichtprobekörpers ist, je geringer ist die unerwünschte Versprödungsneigung.

Die Bestimmung der Wölbung nach Temperaturdauerbelastung kann als Mehrpunktmessung gemäß DIN EN ISO 25178-6:2010-06 mittels konfokaler Mikroskopie (siehe Punkt 3.3.6 der Norm) erfolgen, wobei eine geringe Wölbung für eine geringe Ausbildung innerer Spannungen steht.

Die Erfindung wird im Folgenden anhand von Beispielen erläutert, die jedoch nicht als einschränkend verstanden werden sollen.

Beispiele:

1. Herstellung von Metallpasten:

Zunächst wurden die Vergleichspasten P1-P7 und die erfindungsgemäßen Metallpasten P8-P13 durch Vermischen der einzelnen Bestandteile gemäß nachfolgender Tabelle hergestellt. Alle Mengenangaben bedeuten Gew.-%.

| Vergleichspasten | P1 | P2 | P3 | P4 | P5 | P6 | P7 |
|---|---|---|---|---|---|---|---|
| Silberpartikel | 85 | 75 | 75 | 75 | 80 | 70 | 75 |
| α-Terpineol | 14,8 | 14,8 | 14,8 | 14,8 | 14,8 | 14,8 | 14,8 |
| Ethylcellulose | 0,2 | 0,2 | 0,2 | 0,2 | 0,2 | 0,2 | 0,2 |
| Aluminiumoxid | 0 | 10 | 0 | 0 | 0 | 0 | 0 |
| Wolfram | 0 | 0 | 10 | 0 | 0 | 0 | 0 |
| Aluminiumnitrid | 0 | 0 | 0 | 10 | 5 | 10 | 0 |
| Titandioxid | 0 | 0 | 0 | 0 | 0 | 0 | 10 |

| Erfindungsgemäße Pasten | P8 | P9 | P10 | P11 | P12 | P13 |
|---|---|---|---|---|---|---|
| Silberpartikel | 75 | 80 | 70 | 75 | 80 | 70 |
| α-Terpineol | 14,8 | 14,8 | 14,8 | 14,8 | 14,8 | 14,8 |
| Ethylcellulose | 0,2 | 0,2 | 0,2 | 0,2 | 0,2 | 0,2 |
| Molybdän | 10 | 5 | 15 | 0 | 0 | 0 |
| Mit Silber gecoatete Nickelpartikel | 0 | 0 | 0 | 10 | 5 | 15 |

Silberpartikel: mit 0,6 Gew.-% eines Fettsäuregemischs (Laurinsäure/Stearinsäure im Gewichtsverhältnis 25:75) gecoatete Silberflakes mit d50 = 4 μm
Aluminiumoxid: Partikel mit d50 = 2,5 μm
Wolfram: Partikel mit d50 = 1,5 μm
Aluminiumnitrid: Partikel mit d50 = 1,5 μm
Titandioxid: Partikel mit d50 = 3 μm
Molybdän: Partikel mit d50 = 2,1 μm
Mit Silber gecoatete Nickelpartikel: Nickelkern-Silbermantel-Partikel (Nickel:Silber-Gewichtsverhältnis = 75:25) mit d50 = 5 μm

2. Applikation und Sintern der Metallpasten:

a) Herstellung freier Sinterschichten zur Bestimmung des Elastizitätsmoduls und zur Bestimmung der Wölbung

Die jeweilige Metallpaste wurde mittels Schablonendruck auf die Kupferoxidoberfläche einer Kupferfolie in einer Nassschichtdicke von 150 μm appliziert. Bei der bedruckten Fläche handelte es sich jeweils um ein vollflächiges Rechteck mit den Au-βenmaßen von 2,5 com · 1,0 cm. Anschließend wurde die applizierte Metallpaste getrocknet (30 min bei 120 °C in einem Umlufttrockenofen) und bei 250 °C und 4 MPa Druck 2 min lang gesintert. Die Schichtdicke betrug nach dem Sintern 100 μm. Die gesinterten Metallschichten wurden für die darauffolgenden Untersuchungen von der oxidierten Kupferfolie abgelöst.

b) Herstellung von Proben zur Bestimmung der Scherfestigkeit

Die jeweilige Metallpaste wurde mittels Schablonendruck auf ein DCB-Substrat mit einer Nassschichtdicke von 75 μm und einer Fläche von 4 mm · 4 mm vollflächig appliziert. Anschließend wurde im Umlufttrockenofen bei 120 °C 30 min lang getrocknet. Auf die getrockneten Pasten wurden Siliziumchips mit ihrer Silberkontaktfläche von 4 mg · 4 mm bei einer Temperatur von 150 °C aufgesetzt. Die Siliziumchips wurden bei 4 MPa und 250 °C 2 min lang erhitzt, um die Bauelemente mit dem DCB zu versintern.

Nach dem Sintern wurde die Haftung über die Scherfestigkeit bestimmt. Dabei wurden die Siliziumchips mit einem Schermeißel bei einer Geschwindigkeit von 0,3 mm/s bei 260 °C abgeschert. Die Kraft wurde mittels einer Kraftmessdose aufgenommen (Gerät DAGE 2000 der Firma DAGE, Deutschland)

Elastizitätsmodul und Wölbung der freien Sinterschichten wurden mittels Biegetest ohne bzw. nach einer Temperaturdauerbelastung von 100 Stunden bei 200 °C jeweils gemäß den weiter oben erläuterten Verfahren ermittelt. Nachfolgende Tabelle zeigt die erhaltenen Messergebnisse:

| Paste | Elastizitätsmodul [GPa] | Elastizitätsmodul nach Temperatur-dauerbelastung [GPa] | Wölbung nach Temperatur-dauerbelastung | Schertest [N/mm$^2$] |
|---|---|---|---|---|
| P1 | 14 | 80 | > 1 mm | 23 |
| P2 | 14 | 35 | > 1 mm | 8 |
| P3 | 30 | 30 | > 1 mm | 20 |
| P4 | 12 | 30 | > 1 mm | 15 |
| P5 | 16 | 34 | > 1 mm | 15 |
| P6 | 10 | 28 | > 1 mm | 12 |
| P7 | 15 | 25 | > 1 mm | 9 |
| P8 | 15 | 17 | <50 $\mu$m | 14 |
| P9 | 17 | 19 | <50 $\mu$m | 17 |
| P10 | 10 | 12 | <50 $\mu$m | 10 |
| P11 | 18 | 40 | <50 $\mu$m | 18 |
| P12 | 16 | 43 | <50 $\mu$m | 16 |
| P13 | 10 | 30 | <50 $\mu$m | 12 |

**Patentansprüche**

1. Metallpaste, die (A) 75 bis 90 Gew.-% Kupfer- und/oder Silberpartikel, die ein Coating aufweisen, das wenigstens eine organische Verbindung enthält, (B) 5 bis 20 Gew.-% organisches Lösemittel und (C) 2 bis 20 Gew.-% mindestens einer Art von von Partikeln (A) verschiedenen Metallpartikeln mit einer mittleren Teilchengröße (d50) im Bereich von 0,2 bis 10 $\mu$m enthält, wobei die Metallpartikel der Komponente (C) ausgewählt sind aus der aus Molybdänpartikeln und Nickelkern-Silbermantel-Partikeln mit einem Silbergehalt von 10 bis 90 Gew.-% bestehenden Gruppe, wobei es sich bei der mittleren Teilchengröße (d50) um den mittels Laserbeugung bestimmten mittleren Primärteilchendurchmesser (d50) handelt.

2. Metallpaste nach Anspruch 1, wobei die Kupfer- und/oder Silberpartikel (A) die Form von Flakes aufweisen.

3. Metallpaste nach Anspruch 1 oder 2, wobei die wenigstens eine organische Verbindung ausgewählt ist aus der aus freien Fettsäuren, Fettsäuresalzen und Fettsäureestern bestehenden Gruppe.

4. Metallpaste nach einem der vorhergehenden Ansprüche, wobei der Silbergehalt der Nickelkern-Silbermantel-Partikel im Bereich von 15 bis 30 Gew.-% liegt.

5. Metallpaste nach Anspruch 4, wobei die Nickelkern-Silbermantel-Partikel einen Silbergehalt von 25 Gew.-% haben.

6. Metallpaste nach einem der vorhergehenden Ansprüche, wobei die Partikel (C) weder Flakes noch Nadeln umfassen.

7. Metallpaste nach Anspruch 6, wobei die Partikel (C) einen Formfaktor im Bereich von 1 bis 3 aufweisen.

8. Metallpaste nach einem der vorhergehenden Ansprüche enthaltend neben den Bestandteilen (A) bis (C) 0 bis 12 Gew.-% wenigstens eines Metallprecursors (D), 0 bis 10 Gew.-% wenigstens eines Sinterhilfsmittels (E) und 0 bis 15 Gew.-% eines oder mehrerer weiterer Inhaltsstoffe (F) ausgewählt unter Dispersionsmitteln, Tensiden, Entschäumern, Bindemitteln, Polymeren und/oder viskositätssteuernden Mitteln.

9. Verfahren zum Verbinden von Bauelementen, bei dem man (a) eine Sandwichanordnung bereitstellt, die wenigstens (a1) ein Bauelement 1, (a2) ein Bauelement 2 und (a3) eine Metallpaste nach einem der vorhergehenden Ansprüche aufweist, die sich zwischen Bauelement 1 und Bauelement 2 befindet, und (b) die Sandwichanordnung sintert.

10. Verfahren nach Anspruch 9, wobei man unter Druckanwendung oder drucklos sintert.

11. Verfahren nach einem der Ansprüche 9 oder 10, wobei es sich bei den Bauelementen um in der Elektronik verwendete Teile handelt.

12. Verfahren nach Anspruch 11, wobei es sich bei den Bauelementen um solche mit einer Kontaktfläche im Bereich von > 16 bis 12000 mm$^2$ handelt.

## Claims

1. Metal paste that comprises (A) 75 to 90 % by weight copper and/or silver particles that comprise a coating that contains at least one organic compound, (B) 5 to 20 % by weight organic solvent, and (C) 2 to 20 % by weight of at least one type of metal particles that are different from particles (A) and have a mean particle size (d50) in the range of 0.2 to 10 $\mu$m, whereby the metal particles of component (C) are selected from the group consisting of molybdenum particles and nickel core-silver jacket particles with a silver content of 10 to 90 % by weight, whereby the mean particle size (d50) is the mean primary particle diameter (d50) determined by means of laser diffraction.

2. Metal paste according to claim 1, whereby the copper and/or silver particles (A) take the shape of flakes.

3. Metal paste according to claim 1 or 2, whereby the at least one organic compound is selected from the group consisting of free fatty acids, fatty acid salts, and fatty acid esters.

4. Metal paste according to any one of the preceding claims, whereby the silver content of the nickel core-silver jacket particles is in the range of 15 to 30 % by weight.

5. Metal paste according to claim 4, whereby the nickel core-silver jacket particles have a silver content of 25 % by weight.

6. Metal paste according to any one of the preceding claims, whereby the particles (C) comprise neither flakes nor needles.

7. Metal paste according to claim 6, whereby the particles (C) comprise a shape factor in the range of 1 to 3.

8. Metal paste according to any one of the preceding claims, containing, aside from ingredients (A) to (C), 0 to 12 % by weight of at least one metal precursor (D), 0 to 10 % by weight of at least one sintering aid (E), and 0 to 15 % by weight of one or more further ingredients (F) selected from dispersion agents, surfactants, de-foaming agents, binding agents, polymers and/or viscosity-controlling (rheological) agents.

9. Method for the connecting of components, consisting of (a) providing a sandwich arrangement that comprises at least (a1) one component 1, (a2) one component 2, and (a3) one metal paste according to any one of the preceding claims that is situated between component 1 and component 2, and (b) sintering the sandwich arrangement.

10. Method according to claim 9, whereby the sintering takes place with or without pressure.

11. Method according to either one of claim 9 or 10, whereby the components are parts that are used in electronics.

12. Method according to claim 11, whereby the components are components having a contact surface in the range of > 16 to 12,000 mm$^2$.

**Revendications**

1. Pâte métallique, qui contient (A) 75 à 90 % en poids de particules de cuivre et/ou d'argent, qui comportent un revêtement contenant au moins un composé organique, (B) 5 à 20 % en poids de solvant organique et (C) 2 à 20 % en poids d'au moins un type de particules métalliques différent des particules (A) avec une taille de particule (d50) moyenne comprise dans la plage de 0,2 à 10 μm, les particules métalliques du constituant (C) étant choisies dans le groupe constitué des particules de molybdène et des particules à noyau de nickel et enveloppe d'argent avec une teneur en argent de 10 à 90 % en poids, la taille de particule (d50) moyenne étant le diamètre de particule primaire (d50) moyen déterminé par diffraction laser.

2. Pâte métallique selon la revendication 1, dans laquelle les particules de cuivre et/ou d'argent (A) présentent la forme de paillettes.

3. Pâte métallique selon la revendication 1 ou 2, dans laquelle l'au moins un composé organique est choisi dans le groupe constitué des acides gras libres, des sels d'acides gras et des esters d'acides gras.

4. Pâte métallique selon l'une des revendications précédentes, dans laquelle la teneur en argent des particules à noyau de nickel et enveloppe d'argent est située dans la plage de 15 à 30 % en poids.

5. Pâte métallique selon la revendication 4, dans laquelle les particules à noyau de nickel et enveloppe d'argent ont une teneur en argent de 25 % en poids.

6. Pâte métallique selon l'une des revendications précédentes, dans laquelle les particules (C) ne comprennent ni paillettes, ni aiguilles.

7. Pâte métallique selon la revendication 6, dans laquelle les particules (C) présentent un facteur de forme situé dans la plage de 1 à 3.

8. Pâte métallique selon l'une des revendications précédentes, contenant en plus des constituants (A) à (C) 0 à 12 % en poids d'au moins un précurseur métallique (D), 0 à 10 % en poids d'au moins un adjuvant de frittage (E) et 0 à 15 % en poids d'un ou de plusieurs autres constituants (F) choisis parmi des agents de dispersion, des tensioactifs, des agents antimoussants, des liants, des polymères et/ou des agents de contrôle de la viscosité.

9. Procédé destiné à relier des composants, dans lequel (a) on met à disposition un ensemble en sandwich, qui comporte au moins (a1) un composant 1, (a2) un composant 2 et (a3) une pâte métallique selon l'une des revendications précédentes, qui se trouve entre le composant 1 et le composant 2, et (b) on fritte l'ensemble en sandwich.

10. Procédé selon la revendication 9, dans lequel on fritte avec application de pression ou sans pression.

11. Procédé selon l'une des revendications 9 ou 10, dans lequel les composants sont des pièces utilisées dans l'électronique.

12. Procédé selon la revendication 11, dans lequel les composants sont des composants ayant une surface de contact située dans la plage de > 16 à 12 000 mm$^2$.

**IN DER BESCHREIBUNG AUFGEFÜHRTE DOKUMENTE**

**In der Beschreibung aufgeführte Patentdokumente**

- WO 2011026623 A1
- DE 102009000192 A1